(19) Europäisches Patentamt / European Patent Office / Office européen des brevets

(11) **EP 3 211 583 A2**

(12) **EUROPEAN PATENT APPLICATION**
published in accordance with Art. 153(4) EPC

(43) Date of publication:
**30.08.2017 Bulletin 2017/35**

(51) Int Cl.:
***G06Q 50/08*** (2012.01)   ***G01L 5/00*** (2006.01)

(21) Application number: **15853084.0**

(22) Date of filing: **16.10.2015**

(86) International application number:
**PCT/KR2015/010993**

(87) International publication number:
**WO 2016/064143 (28.04.2016 Gazette 2016/17)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **25.10.2014 KR 20140145602**

(71) Applicant: **Building Magnitude Technology Analysis and Research Service Co. Ltd.**
**Cheongju-si, Chungcheongbuk-do 28351 (KR)**

(72) Inventor: **SHIN, Dong Youl**
**Cheongju-si**
**Chungcheongbuk-do 28746 (KR)**

(74) Representative: **Noble, Frederick**
**Albright IP Limited**
**County House**
**Bayshill Road**
**Cheltenham, Glos. GL50 3BA (GB)**

(54) **METHOD FOR ESTIMATING EARTHQUAKE RESISTANCE MAGNITUDE OF EXISTING STRUCTURE AND SYSTEM THEREFOR**

(57)   A method for calculating an earthquake-resistance for a structure may include an earthquake-resistance calculation using the structure design data; a required ground acceleration calculation wherein at the required ground acceleration, the earthquake-resistance matches the external vibration-force; and an earthquake magnitude calculation wherein the earthquake magnitude is calculated at a predetermined distance at which the required ground acceleration is available.

Figure 1

**Description**

**CROSS-REFERENCE TO RELATED APPLICATION**

This application claims the benefit of Korea patent application No. 10-2014-0145602 filed on October 24, 2014, the entire content of which is incorporated herein by reference for all purposes as if fully set forth herein.

## BACKGROUND

Field of the Present Disclosure

The present disclosure relates to a method and system for calculating an earthquake-resistance for a structure. More particularly, the present disclosure relates to a method and system for calculating an earthquake-resistance for a structure wherein a earthquake-resistance magnitude is calculated based on a distance between the structure site and a predetermined location.

Discussion of the Related Art

Conventionally, certain buildings have not been subjected to the earthquake-resistance design. Thus, the people residing in such buildings may feel anxious when hearing news about an earthquake. Further, an earthquake safety estimation for such buildings may be expensive. Although certain buildings have been subjected to the earthquake-resistance design, those buildings may not endure all range of an earthquake magnitude. The conventional earthquake-resistance design method may not calculate an exact earthquake-magnitude against which the buildings could endure. This is because the conventional earthquake-resistance design method may be based only on a time-related occurrence probability of the earthquake. Moreover, the conventional earthquake-resistance design method may have a following determination in an earthquake-resistance design result check: only when an inter-store displacement is below an acceptable inter-store displacement, it may be safe. Thus, the conventional earthquake-resistance design method may not provide an exact earthquake resistance magnitude of the structure.

## SUMMARY

Thus, the present disclosure to provide the present disclosure relates to a method and system for calculating an earthquake-resistance for a structure wherein an earthquake-resistance magnitude is calculated based on a distance between the structure site and a predetermined location.

In one aspect of the present disclosure, there is provided a method for calculating an earthquake-resistance for a structure using a computing machine, wherein the computing machine includes an interface, a memory, and a processor connected to each other, the method comprising: receiving first information about a structure at a predetermined site by an input of the interface of the computing machine and calculating an earthquake-resistance of the structure by the processor of the computing machine, wherein the first information is related to the earthquake-resistance calculation; receiving second information about the structure and a surrounding ground characteristic by the input of the interface of the computing machine, calculating an external vibration force by the processor of the computing machine, wherein the second information is related to the external vibration force calculation, and calculating a required ground acceleration at which the external vibration force matches the earthquake-resistance by the processor; and calculating, by the processor, an earthquake magnitude at a predetermined distance at which the required ground acceleration is available.

The present method and system for calculating an earthquake-resistance for a structure may provide an exact earthquake resistance magnitude of the structure based on the distance between the structure site and a predetermined location.

Thus, using the present method and system for calculating an earthquake-resistance for a structure, the earthquake-resistance design quality may be evaluated, the non-expert may be interested in the earthquake-resistance design result, the constructed building may have a high reliability, and the building may be evaluated in terms of earthquake-resistance. Thus, the building buyer may reflect the earthquake-resistance in a reliable manner.

## BRIEF DESCRIPTION OF THE DRAWINGS

FIG. 1 shows a block diagram of a system for performing a method for calculating an earthquake-resistance for a structure in accordance with an embodiment of the present disclosure.

FIG. 2 shows a flow chart of a method for calculating an earthquake-resistance for a structure in accordance with an embodiment of the present disclosure.

FIG. 3 shows a flow chart of a operation of calculating a structure vibration-resistance, as shown in FIG. 2.

FIG. 4 shows a flow chart of a operation of calculating a required ground acceleration at which an earthquake-resistance matches an external vibration-force, as shown in FIG. 2.

FIG. 5 shows a flow chart of a operation of calculating an earthquake magnitude at a predetermined distance at which the required ground acceleration is available, as shown in FIG. 2.

FIG. 6 shows a flow chart of a operation of calculating earthquake magnitudes at multiple predetermined distances at which the required ground acceleration is available, as shown in FIG. 2.

FIG. 7 shows an exemplary interface input of a system for performing a method for calculating an earthquake-resistance for a structure in accordance with an embodiment of the present disclosure, wherein the method includes an earthquake-resistance magnitude calculation.

FIG. 8 shows an exemplary interface output of a system for performing a method for calculating an earthquake-resistance for a structure in accordance with an embodiment of the present disclosure, wherein the method includes an earthquake-resistance magnitude calculation.

## DETAILED DESCRIPTIONS

Hereinafter, a method for calculating an earthquake-resistance for a structure and a system for performing the method, in accordance with an embodiment of the present disclosure will be described in details with reference to accompanying drawings. Each of operations of the method for calculating an earthquake-resistance for a structure may include a corresponding computing operation. Thus, the system for performing the method may include a computing module for the corresponding computing operation.

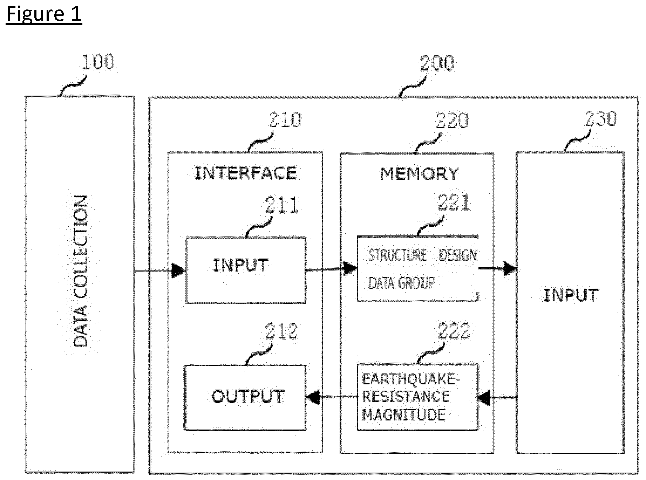

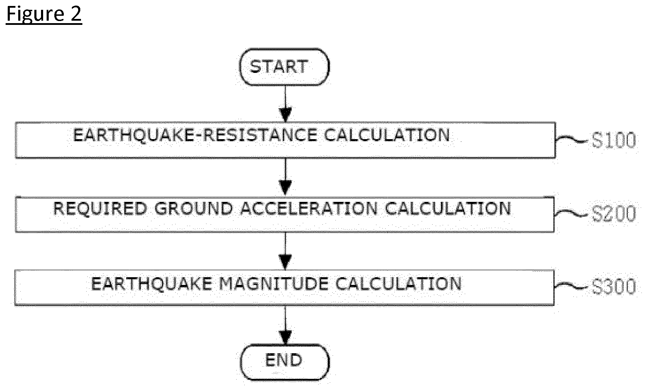

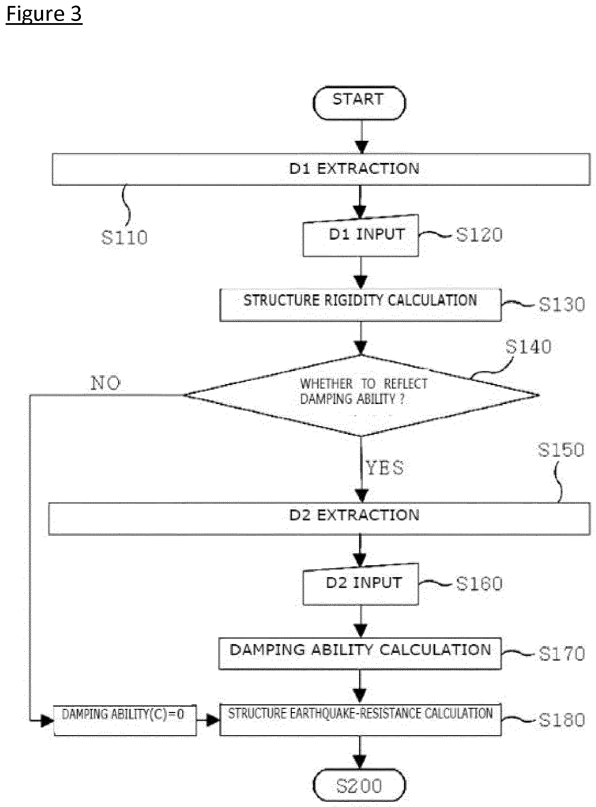

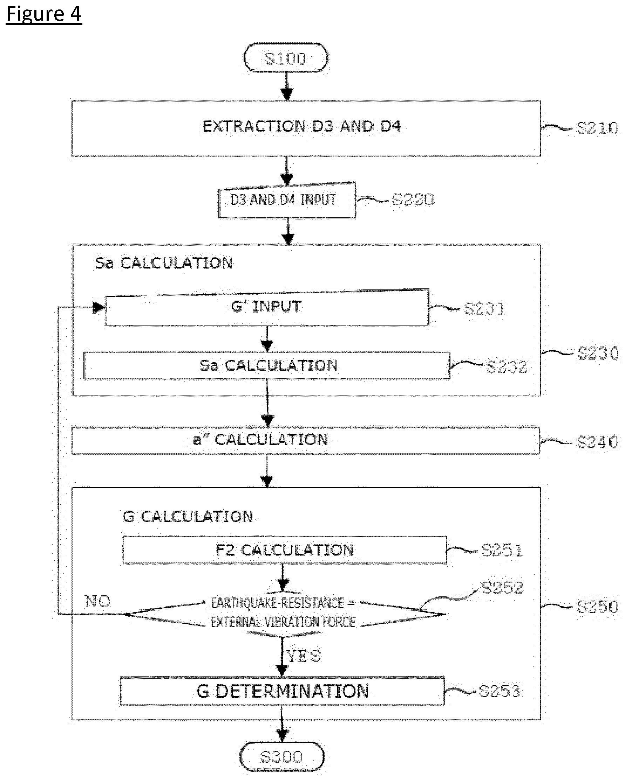

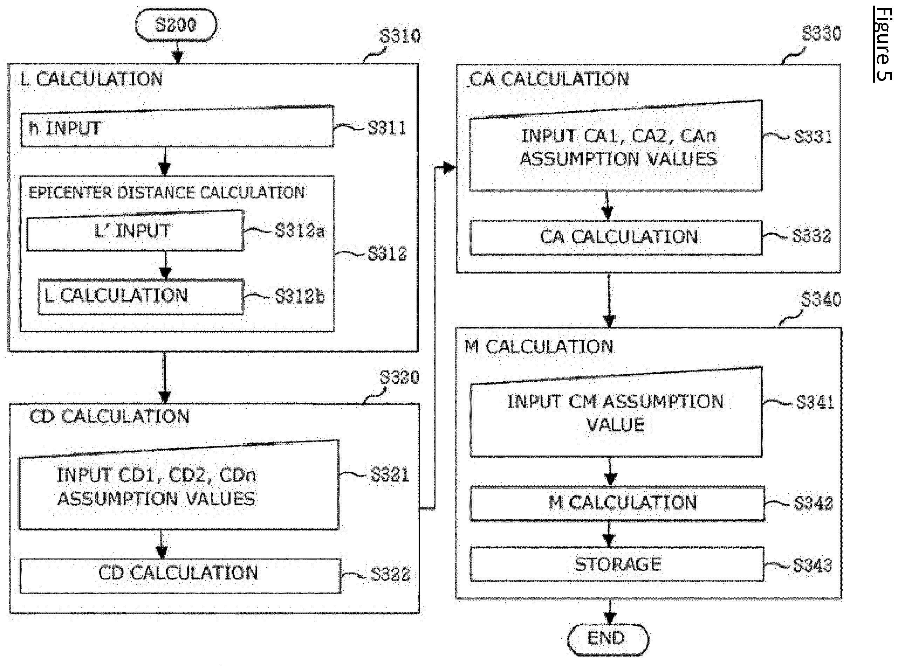

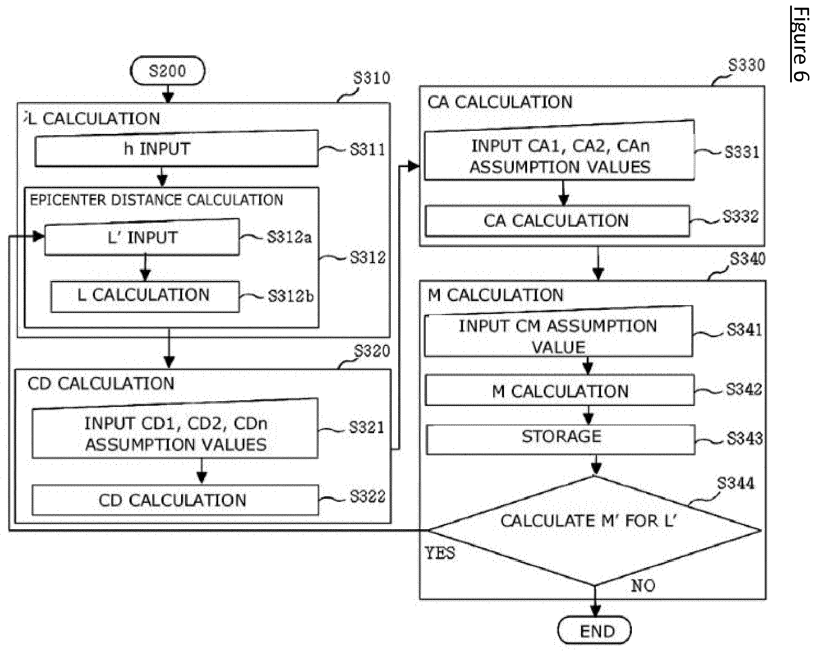

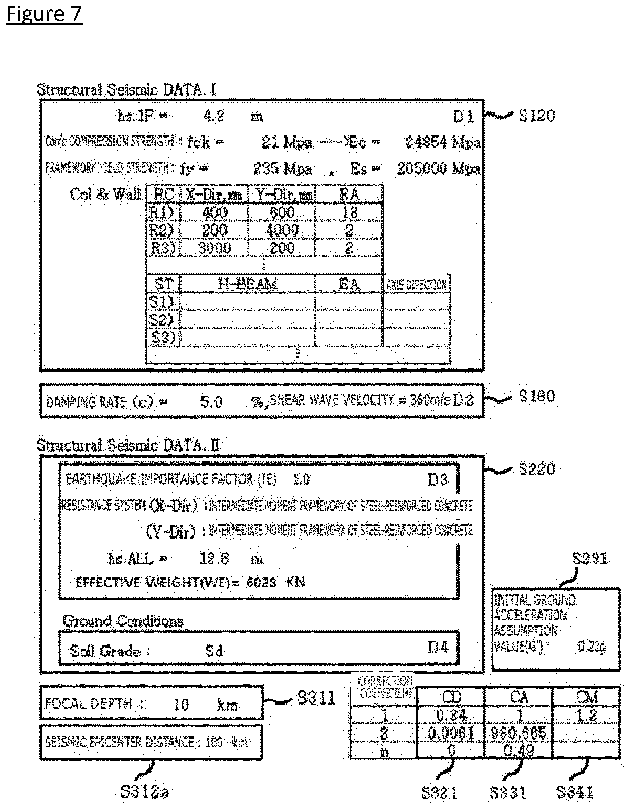

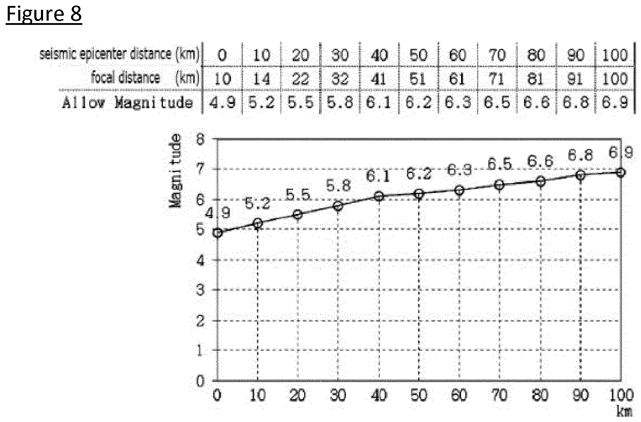

FIG. 1 shows a block diagram of a system 100 and 200 for performing a method for calculating an earthquake-resistance for a structure in accordance with an embodiment of the present disclosure; FIG. 2 shows a flow chart of a method for calculating an earthquake-resistance for a structure in accordance with an embodiment of the present disclosure; FIG. 3 shows a flow chart of a operation S100 of calculating a structure earthquake-resistance S180, as shown in FIG. 2; FIG. 4 shows a flow chart of a operation S200 of calculating a required ground acceleration S253 at which an earthquake-resistance matches an external vibration-force, as shown in FIG. 2; FIG. 5 shows a flow chart of a operation of calculating an earthquake magnitude S342 at a predetermined distance S312b at which the required ground acceleration S253 is available, as shown in FIG. 2; FIG. 6 shows a flow chart of a operation of calculating earthquake magnitudes at multiple predetermined distances at which the required ground acceleration is available, as shown in FIG. 2; FIG. 7 shows an exemplary input 211 of an interface 210 of the system 100 and 200 for performing a method for calculating an earthquake-resistance for a structure in accordance with an embodiment of the present disclosure, wherein the method includes an earthquake-resistance magnitude calculation; and FIG. 8 shows an exemplary output 212 of the interface 210 of the system 100 and 200 for performing a method for calculating an earthquake-resistance for a structure in accordance with an embodiment of the present disclosure, wherein the method includes an earthquake-resistance magnitude calculation.

As shown in FIG. 1, the system 100 and 200 for performing a method for calculating an earthquake-resistance for a structure in accordance with an embodiment of the present disclosure may include a data collection unit 100 and a computing machine 200 coupled to the data collection unit 100. The computing machine 200 may include an interface 210, a processor 230 and a memory 220. In this connection, the interface 210, the processor 230 and the memory 220 may be connected to each other. The data collection unit 100 may collect a structure design data D1 extraction for structure rigidity calculation, and a structure design data D2 extraction for structure damping ability calculation, as shown in FIG. 3; structure design data D3 and surrounding ground characteristic D4 extractions for structure external vibration-force calculation, and a ground acceleration assumption value G', as shown in FIG. 4. Then, the data collection unit 100 may store the above-defined data into the memory 220. In this connection, the interface 210 may include an input 211 and an output 212. The input 211 may receive the structure design data D1 extraction for structure rigidity calculation, and the structure design data D2 extraction for structure damping ability calculation, as shown in FIG. 3; the structure design data D3 and the surrounding ground characteristic D4 extractions for structure external vibration-force calculation, and the ground acceleration assumption value G', as shown in FIG. 4; a focal depth assumption value h, a seismic epicenter distance assumption value L', ground damping coefficients CD1, CD2, CDn assumption values based on hypocenter distances, correction coefficients CA1, CA2, CAn assumption values based on required ground accelerations G, correction coefficient CM assumption values based on site amplification coefficients due to ground characteristics, as shown in FIG. 5 and FIG. 6. The output 212 may output a resultant earthquake-resistance magnitude M. The processor 230 may calculate a structure rigidity K, a structure damping ability C, and a structure earthquake-resistance F1 as shown in FIG. 3; a structure-designed response spectral acceleration Sa, a required acceleration a", an external vibration-force F2, and a required ground acceleration G as shown in FIG. 4; and a hypocenter distance L, a damping value CD based on the hypocenter distance, a required ground acceleration transformation value CA, and an earthquake-resistance magnitude M as shown in FIG. 5 and FIG. 6. The memory 220 may store therein structure design data group 221 for extracting the structure design data D1, D2, D3 and surrounding ground characteristic D4, and the resultant earthquake-resistance magnitude data 222.

The structure earthquake-resistance design system 100 and 200 as shown in FIG. 1 may perform the method for calculating an earthquake-resistance for a structure including the earthquake-resistance magnitude calculation. As shown in FIG. 2, the method for calculating an earthquake-resistance for a structure may include an earthquake-resistance calculation S100 using the structure design data; a required ground acceleration calculation S200 wherein at the required ground acceleration, the earthquake-resistance matches the external vibration-force; and an earthquake magnitude calculation S300 wherein the earthquake magnitude is calculated at a predetermined distance at which the required ground acceleration is available.

First, the earthquake-resistance calculation S100 using the structure design data will be described in details with reference to FIG. 3. The earthquake-resistance calculation S100 may include an operation S110 of extracting structure design data D1 for structure rigidity calculation; an operation S120 of inputting the structure design data D1; an operation S130 of calculating a structure rigidity K; an operation S140 of determining whether to reflect a structure damping ability; an operation S150 of extracting structure design data D2 for structure damping ability calculation; an operation S160 of inputting the structure design data D2; an operation S170 of calculating the structure damping ability C; and an operation S180 of calculating the structure earthquake-resistanceF1. To be more specific, a reference will be made to FIG. 1, FIG. 3 and FIG. 7. In the operation S110, among the structure design data group 221, an elastic modulus and size of at least one vertical member of columns and walls, store and height, earthquake importance factor, etc. may be extracted as the structure design data D1 for the rigidity calculation in FIG. 3. Then, the structure design data D1 may be inputted to the input 211 of the interface 210 as shown in FIG. 7 (S120). Then, the processor 230 as shown in FIG. 1 may perform the structure rigidity K calculation S130 as shown in FIG. 3 using the data D1. To be specific, the processor 230 as shown in FIG. 1 may calculate the rigidity of the vertical member using the elastic modulus and size of the at least one vertical member of columns and walls, and the store and height, and determine a structure earthquake-resistance grade using the earthquake importance factor, and multiply an acceptable inter-store displacement ratio resulting from the structure earthquake-resistance grade by the store and height to calculate an acceptable inter-store displacement, and multiply the calculated rigidity by the acceptable inter-store displacement to calculate the structure rigidity K. Then, in the operation S140, whether to reflect the structure damping ability may be determined.

When the structure damping rate calculation is not available or when the earthquake-resistance is intended to be calculated as a lower value to an actual value to secure reliable earthquake-resistance design, the structure damping rate 0% may be inputted to the input 211 of the interface 210 (S160). To be more specific, the structure damping rate may be generally set as 1% to 10%. When the structure damping ability is reflected to obtain the earthquake-resistance, among the structure design data group 221 in FIG. 1, the structure damping rate (%) and ground shear wave velocity may be extracted as the structure design data D2 for the damping ability calculation as shown in FIG. 3 (S150). Then, the structure design data D2 may be inputted into the input 211 of the interface 210 as shown in FIG. 7 (S160). Then, the processor 230 in FIG. 1 may multiply the damping rate by the ground shear wave velocity to obtain the damping ability C (S170), and may sum the structure rigidity K and structure damping ability C to obtain the structure earthquake-resistance F1. Next, as shown in FIG. 4, the operation S200 of the required ground acceleration may include an operation S210 of extracting structure design data D3 and surrounding ground characteristics D4 for structure external vibration-force calculation; an operation S220 of inputting the structure design data D3 and surrounding ground characteristics D4 for structure external vibration-force calculation; an operation S230 of calculating a structure-designed response spectral acceleration Sa, wherein the operation S230 may include an operation S231 of inputting a ground acceleration assumption value G', and an operation S232 of calculating the structure-designed response spectral acceleration Sa; an operation S232 of summing the ground acceleration assumption value G' and structure-designed response spectral acceleration Sa to obtain the required acceleration a"; and an operation S250 of calculating a structure required ground acceleration G wherein the operation S250 may include an operation S251 of multiplying the required acceleration a" by the structure effective mass to obtain the external vibration-force F2, and an operation S252 of checking whether the external vibration-force F2 matches the earthquake-resistance F1, and an operation S253 of determining the required ground acceleration G. This will be described in details with reference to FIG. 1, FIG. 4 and FIG. 7. In the operation S210, among the structure design data group 221 in FIG, 1, the earthquake importance factor, a height and/or an effective weight of a structure framework earthquake resistance system and a full structure, ground type, etc. may be extracted as the structure design data D3 and surrounding ground characteristic D4 for the structure external vibration-force calculation as shown in FIG. 4. Then, the structure design data D3 and surrounding ground characteristic D4 may be input to the input 211 of the interface 210 (S220). Then, for the structure-designed response spectral acceleration Sa calculation, the ground acceleration assumption value G' may be input to the input 211 of the interface 210 (S231) as shown in FIG. 7 and, then, the processor 230 in FIG. 1 may calculate a natural period and short period and one-second period response spectrums of the structure corresponding to the ground acceleration assumption value G'. The processor may use the calculated natural period and short period and one-second period response spectrums to yield the structure-designed response spectral acceleration Sa (S232). The processor may sum the ground acceleration assumption value G' and the calculated structure-designed response spectral acceleration Sa to obtain the required acceleration a" (S240). The processor may multiply the required acceleration a" by the effective weight among the structure design data D3 to obtain an inertial force as the external vibration-force F2 (S251). The processor may determine whether the external vibration-force F2 matches the earthquake-resistance F1 (S252). Upon determination that the external vibration-force F2 does not match the earthquake-resistance F1, the above defined calculations may be repeated until a difference therebetween reaches "0", wherein the above defined calculations may be repeated while adding or subtracting a predetermined small amount to the input ground acceleration assumption value. Upon determination that the external vibration-force F2 matches the earthquake-resistance F1, the required ground acceleration G may be determined (S253).

Next, the earthquake magnitude calculation operation S300 will be described. As shown in FIG. 5 and FIG. 6, the earthquake magnitude calculation operation S300 may include an operation S310 of calculating a distance L between the hypocenter and structure provided that the earthquake occurs, wherein the operation S310 include an operation S311 of inputting a focal depth assumption value h, an operation S312a of inputting a seismic epicenter distance assumption value L', and a hypocenter distance calculation operation S312 of calculating a hypocenter distance L; an operation S321 of inputting the ground damping coefficient CD1, CD2, CDn assumption values based on the hypocenter distances L; an operation S322 of calculating a damping value CD based on the hypocenter distance L; an operation S330 of calculating a required ground acceleration transformation value CA, wherein the operation S330 includes an operation S331 of correction coefficient CA1, CA2, CAn assumption values based on required ground accelerations G, and an operation S332 of calculating a required ground acceleration transformation value CA at the structure site; and an operation 340 including an operation S341 of inputting a correction coefficient assumption value CM reflecting ground amplifications base on the ground characteristic, an operation S342 of calculating an earthquake magnitude M and an operation S343 of storing the calculated earthquake magnitude M. Optionally, as show in FIG. 6, the earthquake magnitude calculation operation S300 may further include an operation S344 of determining whether a further earthquake-resistance magnitude M' is calculated for a further hypocenter distance L'. This will be described in details with reference to FIG. 1, FIG. 5, FIG. 6, FIG. 7, and FIG. 8. For the calculation operation of the distance L between the hypocenter and structure site provided that the earthquake occurs, the focal depth assumption value h and seismic epicenter distance assumption value L' may be inputted to the input 211 of the interface 210 as shown in FIG. 7 (S311, S312a), and the processor 230 in FIG. 1 may calculate the hypocenter distance L, and may set damping coefficients CD1, CD2, CDn based on the calculated hypocenter distances L. Then, the damping coefficients CD1, CD2, CDn may be inputted to the input 211 of the interface 210 as shown in FIG. 7 (S321). The processor 230 in FIG. 1 may calculate a damping value CD based on the hypocenter distance S322. In this connection, the damping value CD calculation based on the hypocenter distance may be conducted as follows:

$$CD = CD1*\ln (L) + CD2*L + CDn \ ......equation \ (1)$$

where, L refers to the hypocenter distance (km unit), ln(L) refers to a natural logarithm value for the hypocenter distance L, CD1 refers to the damping coefficient for the hypocenter distance, CD2 refers to the damping coefficient for the hypocenter distance natural logarithm value, and CDn refers to a further correction damping coefficient.

Further, the correction coefficients CA1, CA2, CAn based on the calculated required ground accelerations G may be inputted to the input 211 of the interface 210 as shown in FIG. 7 (S331). Then, the processor 230 may calculate the required ground acceleration transformation value CA using the correction coefficients CA1, CA2, CAn as follows:

$$CA = [\ln(CA1*A) - CA2] / CAn \ ...... \ equation \ 2$$

where, A refers to the calculated required ground acceleration (gravitational acceleration unit g), CA1 refers to an unit correction coefficient for transformation of the required ground acceleration g to $cm/s^2$ unit (about 980 or more precisely 980.665), CA2 and CAn refer to correction coefficients for transformation of the unit-transformed required ground acceleration natural logarithm value to an earthquake magnitude at the structure site.

Furthermore, the correction coefficient CM assumption value reflecting ground amplification based on the ground characteristic may be inputted to the input 211 of the interface 210 as shown in FIG. 7 (S341). The processor 230 in FIG. 1 may calculate an earthquake magnitude at a hypocenter distance from the structure site (S342). That is, the calculated refers to a threshold earthquake-resistance magnitude M at which the structure dose not collapse due to the earthquake-resistance. The earthquake-resistance magnitude M may be calculated as follows:

$$M = [CD+CA]/CM \quad ...... \quad \text{equation 3}$$

where CD refers to a damping value based on a hypocenter distance according to the equation 1, CA refers to a required ground acceleration transformation value according to the equation 2, CM refers to the correction coefficient reflecting ground amplification based on the ground characteristic, wherein the softer the ground is, the larger the ground amplification.

Finally, the earthquake magnitude (S342) may be stored in the memory 220 in FIG. 1 as an earthquake-resistance magnitude data 222 (S343). As shown in FIG. 6, the determination may be made about whether to calculate a further earthquake-resistance magnitude M' for a further hypocenter distance L' (S344). Upon determination to calculate the further earthquake-resistance magnitude M', a further seismic epicenter distance assumption value may be input to the input 211 of the interface 210 as shown in FIG. 7 (S312a). Then, the damping coefficient assumption values CD1, CD2, CDn for the further hypocenter distance L' may be input (S321) and, the correction coefficient assumption values CA1, CA2, CAn, CM may be input (S331, S341) as the previous or new assumption values. Then, the processor 230 may store a further calculated earthquake magnitude S343 for the further hypocenter distance L' to the memory 220 as the earthquake-resistance magnitude data 222 (S343). The result may be output to the output 212 of the interface 210 as shown in FIG. 8.

Examples of various embodiments are illustrated in the accompanying drawings and described further below. It will be understood that the description herein is not intended to limit the claims to the specific embodiments described. On the contrary, it is intended to cover alternatives, modifications, and equivalents as may be included within the spirit and scope of the present disclosure as defined by the appended claims. Example embodiments will be described in more detail with reference to the accompanying drawings. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

**Claims**

1. A method for calculating an earthquake-resistance for a structure using a computing machine, wherein the computing machine includes an interface, a memory, and a processor connected to each other, the method comprising:

   (a) receiving first information about a structure at a predetermined site by an input of the interface of the computing machine and calculating an earthquake-resistance of the structure by the processor of the computing machine, wherein the first information is related to the earthquake-resistance calculation;
   (b) receiving second information about the structure and a surrounding ground characteristic by the input of the interface of the computing machine, calculating an external vibration force by the processor of the computing machine, wherein the second information is related to the external vibration force calculation, and calculating a required ground acceleration at which the external vibration force matches the earthquake-resistance by the processor; and
   (c) calculating, by the processor, an earthquake magnitude at a predetermined distance at which the required ground acceleration is available.

2. The method of claim 1, wherein the operation (a) includes:

   receiving, by the input, an elastic modulus and size of each vertical member at each store of the structure, a number of stores and a height of the structure, and an earthquake importance factor for rigidity calculation for the structure;
   calculating, by the processor, a total rigidity of all vertical members in the structure using the elastic modulus and size of each vertical member at each store of the structure, and the number of the stores and height of the structure,
   calculating, by the processor, a structure earthquake-resistance grade and an acceptable inter-store displacement ratio using the earthquake importance factor;
   calculating, by the processor, an acceptable inter-store displacement by multiplying the acceptable inter-store displacement ratio by the number of the stores and height of the structure;
   calculating, by the processor, the structure rigidity by multiplying the calculated total rigidity by the acceptable inter-store displacement;

receiving, by the input, a damping rate of the structure, and a ground shear wave velocity;

calculating, by the processor, a damping ability of the structure by multiplying the damping rate by the ground shear wave velocity; and

calculating, by the processor, the structure earthquake-resistance by summing the structure rigidity and structure damping ability.

3. The method of claim 1, wherein the operation (b) includes:

receiving, by the input, an earthquake importance factor, a height and/or an effective weight of a structure framework earthquake resistance system and a full structure and a ground type;

receiving, by the input, a ground acceleration assumption value for the site;

processing, by the processor, the earthquake importance factor, the height and/or an effective weight and the ground type to calculate a natural period and short period and one-second period response spectrums of the structure corresponding to the ground acceleration assumption value;

calculating, by the processor, a structure-designed response spectral acceleration using the calculated natural period and short period and

one-second period response spectrums;

calculating, by the processor, a required acceleration by summing the ground acceleration assumption value and the calculated structure-designed response spectral acceleration;

calculating, by the processor, the external vibration-force by multiplying the required acceleration by the effective weight;

determining, by the processor, whether the external vibration-force matches the earthquake-resistance; and

determining, by the processor, the required ground acceleration at which the external vibration-force matches the earthquake-resistance.

4. The method of claim 1, wherein the operation (c) includes:

receiving, by the input, a focal depth assumption value and a seismic epicenter distance assumption value;

calculating, by the processor, a hypocenter distance based on the focal depth assumption value and the seismic epicenter distance assumption value;

receiving, by the input, a ground damping coefficient assumption value for the hypocenter distance;

calculating, by the processor, a damping value based on the hypocenter distance using the hypocenter distance, and the ground damping coefficient assumption value;

receiving, by the input, a correction coefficient assumption value for the required ground acceleration;

calculating, by the processor, a required ground acceleration transformation value using the required ground acceleration, and the correction coefficient assumption value;

receiving, by the input, a correction coefficient assumption value reflecting ground amplification based on a ground characteristic at the site; and

calculating, by the processor, the earthquake magnitude at the distance at which the required ground acceleration is available,

wherein the earthquake magnitude is calculated based on the damping value, the transformation value, and the correction coefficient assumption value.

5. The method of claim 4, comprising a further earthquake magnitude calculation including:

receiving, by the input, a further focal depth assumption value and a further seismic epicenter distance assumption value;

calculating, by the processor, a further hypocenter distance based on the further focal depth assumption value and the further seismic epicenter distance assumption value;

receiving, by the input, a further ground damping coefficient assumption value for further the hypocenter distance as a new or previous value;

calculating, by the processor, a further damping value based on the further hypocenter distance using the further hypocenter distance, and the further ground damping coefficient assumption value;

receiving, by the input, a further correction coefficient assumption value for the required ground acceleration as a new or previous value;

calculating, by the processor, a further required ground acceleration transformation value using the required ground acceleration, and the further correction coefficient assumption value;

receiving, by the input, a further correction coefficient assumption value reflecting ground amplification for the further hypocenter distance as a new or previous value; and

calculating, by the processor, the further earthquake magnitude at the distance at which the required ground acceleration is available,

wherein the further earthquake magnitude is calculated based on the further damping value, the further transformation value, and the further correction coefficient assumption value.

6. A computing machine for calculating an earthquake-resistance for a structure, wherein the machine comprises an input, a processor coupled to the input, an output coupled to the processor, and a memory coupled to the processor and input,

wherein the input is configured to receive input information including first structure data extractions for structure rigidity calculation, second structure data extractions for structure damping ability calculation, third structure data and surrounding ground characteristic extractions for external vibration-force calculation, a ground acceleration assumption value, a focal depth assumption value, a seismic epicenter distance assumption value, a ground damping coefficient assumption value based on the hypocenter distance, a correction coefficient assumption value based on a required ground acceleration, and a correction coefficient assumption value based on a site amplification coefficient resulting from a ground characteristic,

wherein the processor is configured to calculate, based on the input information, output information including a structure rigidity, a structure damping ability, a structure earthquake-resistance, a structure-designed response spectral acceleration, a required acceleration, an external vibration-force, a required ground acceleration, a hypocenter distance, a damping value based on the hypocenter distance, a required ground acceleration transformation value, and/or an earthquake-resistance magnitude,

wherein the output is configured to output the output information, wherein the memory is configured to store therein the input and output information.

Figure 1

| | | 100 | | 200 | |
| DATA COLLECTION | | | | | |

INTERFACE 210     MEMORY 220     230

INPUT 211

STRUCTURE DESIGN DATA GROUP 221

OUTPUT 212

EARTHQUAKE-RESISTANCE MAGNITUDE 222

INPUT

Figure 2

Figure 3

START

D1 EXTRACTION — S110

D1 INPUT — S120

STRUCTURE RIGIDITY CALCULATION — S130

WHETHER TO REFLECT DAMPING ABILITY ? — S140

NO

YES

D2 EXTRACTION — S150

D2 INPUT — S160

DAMPING ABILITY CALCULATION — S170

DAMPING ABILITY(C)=0

STRUCTURE EARTHQUAKE-RESISTANCE CALCULATION — S180

S200

EP 3 211 583 A2

Figure 4

Figure 5

EP 3 211 583 A2

```
                    ┌─────────┐
                    │  S200   │
                    └────┬────┘
                         │
                         ▼
┌─────────────────────────────────────────┐  S310
│ L CALCULATION                            │
│  ┌────────────────────────────────────┐  │
│  │ h INPUT                            │──┼─ S311
│  └─────────────────┬──────────────────┘  │
│                    ▼                      │
│  ┌────────────────────────────────────┐  │
│  │ EPICENTER DISTANCE CALCULATION     │  │
│  │  ┌──────────────────────┐          │  │
│  │  │ L' INPUT             │─── S312a  │──┼─ S312
│  │  └──────────┬───────────┘          │  │
│  │             ▼                      │  │
│  │  ┌──────────────────────┐          │  │
│  │  │ L CALCULATION        │─── S312b  │  │
│  │  └──────────────────────┘          │  │
│  └────────────────────────────────────┘  │
└──────────────────────┬───────────────────┘
                       │
                       ▼
┌─────────────────────────────────────────┐  S320
│ CD CALCULATION                           │
│  ┌────────────────────────────────────┐  │
│  │ INPUT CD1, CD2, CDn                │──┼─ S321
│  │ ASSUMPTION VALUES                  │  │
│  └─────────────────┬──────────────────┘  │
│                    ▼                      │
│  ┌────────────────────────────────────┐  │
│  │ CD CALCULATION                     │──┼─ S322
│  └────────────────────────────────────┘  │
└───────────────────────────────────────────┘
```

```
┌─────────────────────────────────────────┐  S330
│ CA CALCULATION                           │
│  ┌────────────────────────────────────┐  │
│  │ INPUT CA1, CA2, CAn                │──┼─ S331
│  │ ASSUMPTION VALUES                  │  │
│  └─────────────────┬──────────────────┘  │
│                    ▼                      │
│  ┌────────────────────────────────────┐  │
│  │ CA CALCULATION                     │──┼─ S332
│  └────────────────────────────────────┘  │
└──────────────────────┬───────────────────┘
                       │
                       ▼
┌─────────────────────────────────────────┐  S340
│ M CALCULATION                            │
│  ┌────────────────────────────────────┐  │
│  │ INPUT CM ASSUMPTION                │──┼─ S341
│  │ VALUE                              │  │
│  └─────────────────┬──────────────────┘  │
│                    ▼                      │
│  ┌────────────────────────────────────┐  │
│  │ M CALCULATION                      │──┼─ S342
│  └─────────────────┬──────────────────┘  │
│                    ▼                      │
│  ┌────────────────────────────────────┐  │
│  │ STORAGE                            │──┼─ S343
│  └────────────────────────────────────┘  │
└──────────────────────┬───────────────────┘
                       │
                       ▼
                 ┌─────────┐
                 │   END   │
                 └─────────┘
```

Figure 6

EP 3 211 583 A2

## Figure 7

Structural Seismic DATA. I

| | | | | |
|---|---|---|---|---|
| hs.1F = 4.2 m | | | | D1 |

S120

Con'c COMPRESSION STRENGTH : fck = 21 Mpa ——>Ec = 24854 Mpa

FRAMEWORK YIELD STRENGTH: fy = 235 Mpa , Es = 205000 Mpa

Col & Wall

| RC | X-Dir, mm | Y-Dir, mm | EA |
|---|---|---|---|
| R1) | 400 | 600 | 18 |
| R2) | 200 | 4000 | 2 |
| R3) | 3000 | 200 | 2 |
| ⋮ | | | |

| ST | H-BEAM | EA | AXIS DIRECTION |
|---|---|---|---|
| S1) | | | |
| S2) | | | |
| S3) | | | |
| ⋮ | | | |

DAMPING RATE (c) = 5.0 %, SHEAR WAVE VELOCITY = 360m/s D2 —— S160

Structural Seismic DATA. II

EARTHQUAKE IMPORTANCE FACTOR (IE) 1.0    D3    —— S220

RESISTANCE SYSTEM (X-Dir) : INTERMEDIATE MOMENT FRAMEWORK OF STEEL-REINFORCED CONCRETE

(Y-Dir) : INTERMEDIATE MOMENT FRAMEWORK OF STEEL-REINFORCED CONCRETE

hs.ALL = 12.6 m

EFFECTIVE WEIGHT(WE)= 6028 KN

Ground Conditions

Soil Grade : Sd    D4

S231

INITIAL GROUND ACCELERATION ASSUMPTION VALUE(G') : 0.22g

FOCAL DEPTH : 10 km —— S311

SEISMIC EPICENTER DISTANCE : 100 km

S312a

| CORRECTION COEFFICIENT | CD | CA | CM |
|---|---|---|---|
| 1 | 0.84 | 1 | 1.2 |
| 2 | 0.0061 | 980.665 | |
| n | 0 | 0.49 | |

S321    S331    S341

## Figure 8

| seismic epicenter distance (km) | 0 | 10 | 20 | 30 | 40 | 50 | 60 | 70 | 80 | 90 | 100 |
|---|---|---|---|---|---|---|---|---|---|---|---|
| focal distance (km) | 10 | 14 | 22 | 32 | 41 | 51 | 61 | 71 | 81 | 91 | 100 |
| Allov Magnitude | 4.9 | 5.2 | 5.5 | 5.8 | 6.1 | 6.2 | 6.3 | 6.5 | 6.6 | 6.8 | 6.9 |

## REFERENCES CITED IN THE DESCRIPTION

**Patent documents cited in the description**

- KR 1020140145602